# EUROPEAN PATENT APPLICATION

(11) **EP 4 582 869 A1**
(43) Date of publication of application: **09.07.2025**
(21) Application number: 24150650.0
(22) Date of filing: 08.01.2024
(51) Int. Cl.: G03F 7/00, G02B 27/10, G01J 3/12

(54) **COLOUR SELECTION MODULE**

(71) Applicant: ASML Netherlands B.V., 5500 AH Veldhoven (NL)
(72) Inventor: VAN VOORST, Peter, Danny, 5500 AH Veldhoven (NL)
(74) Representative: ASML Netherlands B.V.

(57) **Abstract**

A colour selection module, for outputting radiation having a desired spectral bandwidth and central wavelength, comprises: a radiation input for receiving an input beam of radiation; a first dispersive arrangement for receiving the input beam of radiation from the radiation input and outputting a first dispersed beam of radiation; a second dispersive arrangement for receiving at least a portion of the first dispersed beam of radiation and outputting a second dispersed beam of radiation; a radiation output arrangement for receiving said second dispersed beam of radiation and outputting said second dispersed beam of radiation from the colour selection module, whereby rotation of the second dispersive arrangement changes a second direction of travel and a second spatial distribution of the second dispersed beam of radiation, and hence spectral bandwidth and central wavelength of said second dispersed beam of radiation received and output by the radiation output arrangement.

## Description

### FIELD

The present invention relates to a colour selection module. The colour selection module may form part of a metrology tool. The colour selection module and/or metrology tool may form part of a lithographic apparatus. The present invention also relates to associated methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

Metrology tools, such as a scatterometer, topography measurement system, or position measurement system are used to measure properties of substrates. The measurements may be performed after exposure of a substrate. The measurements may be used to adjust operation of the lithographic apparatus that exposed the substrate to improve pattern reproduction. Adjustments may include modifying the illumination scheme and/or, adjusting the projection optics.

The properties of the radiation used by a metrology tool may affect the type and quality of measurements that may be performed. For some applications, it may be advantageous to use multiple radiation frequencies to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data. The different frequencies may for example be provided as a sequence of different frequencies (i.e. a series of frequencies). Different radiation frequencies may also be able to interrogate and discover different properties of a metrology target. Broadband radiation may be useful in metrology systems such as for example level sensors, alignment mark measurement systems, scatterometry tools, or inspection tools. A broadband radiation source may be a supercontinuum source.

A controllable colour selection module may be used to select a desired narrowband radiation from the broadband radiation with which to illuminate a substrate for a measurement, and may then select another desired narrowband radiation to illuminate the substrate for a subsequent measurement. The colour selection module may be used to select both the central wavelength and spectral bandwidth of a desired narrowband radiation.

Existing colour selection modules may include a pair of colour wheels through which the broadband radiation is directed to produce the desired narrowband radiation. The colour wheels may each be considered to be multilayer (spectral) filters, the properties of which vary with angular location around the wheel. By controlling the angular position of each of the colour wheels, this controls the properties of the portion of each of the colour wheels through which the broadband radiation passes and can thereby control properties of the narrowband radiation which is produced by the colour wheels and hence the colour selection module.

Existing colour selection modules which include colour wheels suffer from the disadvantage that changing the positions of the colour wheels and hence changing the desired narrowband radiation is difficult and/or slow. This has the effect of reducing the speed / throughput of the metrology tool and hence lithographic apparatus of which the metrology tool forms part.

The present invention seeks to provide a colour selection module which overcomes disadvantages of existing colour selection modules, whether discussed above or otherwise. The present invention also provides an alternative colour selection module.

### SUMMARY

According to a first aspect of the invention there is provided a colour selection module, for outputting radiation having a desired spectral bandwidth and central wavelength, comprising: a radiation input for receiving an input beam of radiation;
a first dispersive arrangement for receiving the input beam of radiation from the radiation input and outputting a first dispersed beam of radiation; a second dispersive arrangement for receiving at least a portion of the first dispersed beam of radiation and outputting a second dispersed beam of radiation; a radiation output arrangement for receiving at least a portion of said second dispersed beam of radiation and outputting said at least a portion of said second dispersed beam of radiation from the colour selection module; wherein a portion of the first dispersive arrangement coupled to a first actuator for rotating said portion of the first dispersive arrangement; and a portion of the second dispersive arrangement being coupled to a second actuator for rotating said portion of the second dispersive arrangement, whereby rotation of said portion of the second dispersive arrangement changes a second direction of travel and a second spatial distribution of the second dispersed beam of radiation, and hence spectral bandwidth and central wavelength of said at least a portion of said second dispersed beam of radiation received and output by the radiation output arrangement.

In use, the portion of the first dispersive arrangement may be rotated by the first actuator to a first angular position and the portion of the second dispersive arrangement may be rotated by the second actuator to a second angular position, such that the spectral bandwidth and central wavelength of said at least a portion of said second dispersed beam of radiation received and output by the radiation output arrangement corresponds to the desired spectral bandwidth and central wavelength.

The spectral bandwidth and central wavelength of the said at least a portion of said second dispersed beam of radiation may define a wavelength band of the said at least a portion of said second dispersed beam of radiation

Where it is said that a portion of the first dispersive arrangement is coupled to a first actuator, and a portion of the second dispersive arrangement is coupled to a second actuator, by coupled, the relevant actuator may be mechanically linked to the relevant portion by a linkage. Alternatively, the relevant actuator may be indirectly linked to the relevant portion, for example by magnets.

Rotation of said portion of the first dispersive arrangement may change a first angle of incidence of the input beam of radiation on said portion of the first dispersive arrangement.

Rotation of said portion of the first dispersive arrangement may change a first direction of travel and a first spatial distribution of the first dispersed beam of radiation.

Rotation of said portion of the second dispersive arrangement may change a second angle of incidence of the first dispersed beam of radiation on said portion of the second dispersive arrangement.

The first dispersive arrangement may comprise a prism and said portion of the first dispersive arrangement may be said prism.

The first dispersive arrangement may comprise a reflection grating and said portion of the first dispersive arrangement may be said reflection grating.

The first dispersive arrangement may comprise a transmission grating and said portion of the first dispersive arrangement may be said transmission grating.

The first dispersive arrangement may comprise a transmission grating, which receives the input beam of radiation and outputs a first intermediate dispersion beam which is incident on a first dispersion reflector, the first dispersion reflector outputting said first dispersed beam of radiation; and wherein said portion of the first dispersive arrangement may be said first dispersion reflector.

The second dispersive arrangement may comprise a second prism and said portion of the second dispersive arrangement may be said second prism.

The second dispersive arrangement may comprise a second reflection grating and said portion of the second dispersive arrangement may be said second reflection grating.

The second dispersive arrangement may comprise a second transmission grating and said portion of the second dispersive arrangement may be said second transmission grating.

The second dispersive arrangement may comprise a second transmission grating, which receives said at least a portion of the first dispersed beam of radiation and outputs a second intermediate dispersion beam which is incident on a second dispersion reflector, the second dispersion reflector outputting said second dispersed beam of radiation; and wherein said portion of the second dispersive arrangement may be said second dispersion reflector.

The radiation output arrangement may comprise a spatial filter through which said at least a portion of said second dispersed beam of radiation passes.

The spatial filter may be an aperture.

The radiation output arrangement may further comprise an output reflector for receiving said at least a portion of said second dispersed beam of radiation, travelling in a third direction of travel, once it has passed through the aperture and output the received said at least a portion of said second dispersed beam of radiation in a fourth direction of travel, different to the third direction of travel.

The output reflector may be coupled to a third actuator for rotating the output reflector, whereby rotation of the output reflector changes a third angle of incidence of said at least a portion of said second dispersed beam of radiation on the output reflector and hence the fourth direction of travel of the radiation output from the output reflector.

The third actuator may be mechanically linked to the output reflector by a linkage. Alternatively, the third actuator may be indirectly linked to the output reflector, for example by magnets.

The radiation output arrangement may further comprise a retroreflector for receiving said at least a portion of said second dispersed beam of radiation, travelling in a third direction of travel, once it has passed through the aperture and outputting the received said at least a portion of said second dispersed beam of radiation in a fourth direction of travel, opposite to the third direction of travel.

The radiation output arrangement may further comprise a second reflector, for receiving said at least a portion of said second dispersed beam of radiation output by the retroreflector, after said at least a portion of said second dispersed beam of radiation output by the retroreflector has interacted with the second dispersive arrangement and first dispersive arrangement, and consequently output a recombined beam having a beam path which is different to that of said beam path of the input beam of radiation. In this context, "different to" may mean non-parallel to.

At least one of the first and second actuators, or both of the first and second actuators, may comprise a galvanometer mechanism.

According to a second aspect of the invention there is provided a metrology tool comprising the colour selection module of the preceding aspect of the invention.

The colour selection module for outputting radiation having a desired spectral bandwidth and central wavelength, and the metrology tool is operable to use said radiation as an illumination source for measuring structures or patterns on a substrate.

According to a third aspect of the invention there is provided a lithographic apparatus comprising the colour selection module of the first aspect of the invention or the metrology tool of the second aspect of the invention.

According to a fourth aspect of the invention there is provided a method of operating a colour selection module to output radiation having a desired spectral bandwidth and central wavelength, the colour selection module comprising: receiving an input beam of radiation; a first dispersive arrangement receiving the input beam of radiation from the radiation input and outputting a first dispersed beam of radiation; a second dispersive arrangement receiving at least a portion of the first dispersed beam of radiation and outputting a second dispersed beam of radiation; a radiation output arrangement receiving at least a portion of said second dispersed beam of radiation and outputting said at least a portion of said second dispersed beam of radiation from the colour selection module; rotating to a first angular position a portion of the first dispersive arrangement; rotating to a second angular position a portion of the second dispersive arrangement; and setting the first angular position of said portion of the first dispersive arrangement and the second angular position of said portion of the second dispersive arrangement based on said desired spectral bandwidth and central wavelength.

Rotation of said portion of the first dispersive arrangement may change a first angle of incidence of the input beam of radiation on said portion of the first dispersive arrangement.

Rotation of said portion of the second dispersive arrangement may change a second angle of incidence of the first dispersed beam of radiation on said portion of the second dispersive arrangement.

The desired spectral bandwidth and central wavelength may define a desired wavelength band of radiation.

The colour selection module may comprises a radiation input, said radiation input receiving said input beam of radiation.

Said portion of the first dispersive arrangement may be coupled to a first actuator, said first actuator rotating the portion of the first dispersive arrangement to the first angular position.

Said portion of the second dispersive arrangement may be coupled to a second actuator, said second actuator rotating the portion of the second dispersive arrangement to the second angular position.

Rotation of said portion of the first dispersive arrangement may change a first direction of travel and a first spatial distribution of the first dispersed beam of radiation.

Rotation of said portion of the second dispersive arrangement may change a second direction of travel and a second spatial distribution of the second dispersed beam of radiation, and hence spectral bandwidth and central wavelength of said at least a portion of said second dispersed beam of radiation received and output by the radiation output arrangement.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic representation of a scatterometer;
- Figure 5 depicts a schematic representation of a level sensor;
- Figure 6 depicts an alignment sensor;
- Figure 7 depicts a schematic representation of a known type of colour selection module;
- Figure 8 depicts a schematic representation of a first embodiment of a colour selection module in accordance with the present invention;
- Figure 9 depicts a schematic representation of a second embodiment of a colour selection module, from above, in accordance with the present invention;
- Figure 9a depicts the embodiment of colour selection module shown in Figure 9, from the side;
- Figure 10 depicts a schematic model which can be used to model performance parameters of the embodiments shown in Figures 8 and 9;
- Figures 11 to 16 depict plots of spectral bandwidth against central wavelength for several arrangements modelled using the schematic model depicted in Figure 10;
- Figure 17 depicts a schematic representation of a third embodiment of a colour selection module in accordance with the present invention;
- Figure 18 depicts a schematic representation of a fourth embodiment of a colour selection module in accordance with the present invention; and
- Figure 19 depicts a schematic representation of a fifth embodiment of a colour selection module in accordance with the present invention.

### DETAILED DESCRIPTION

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

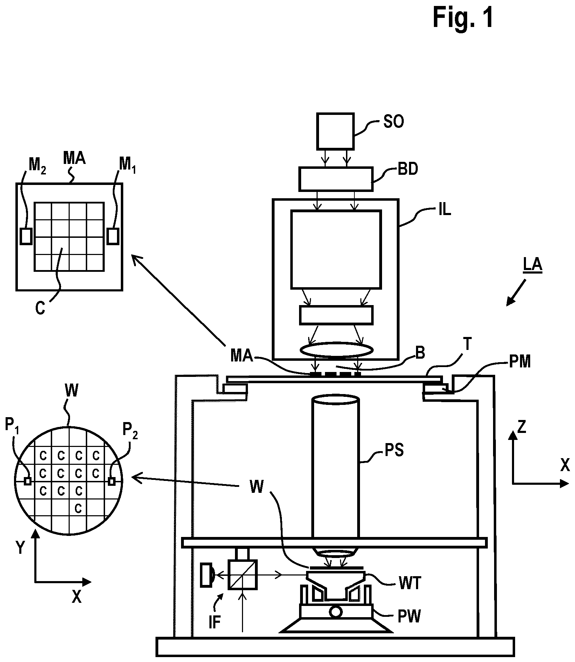

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

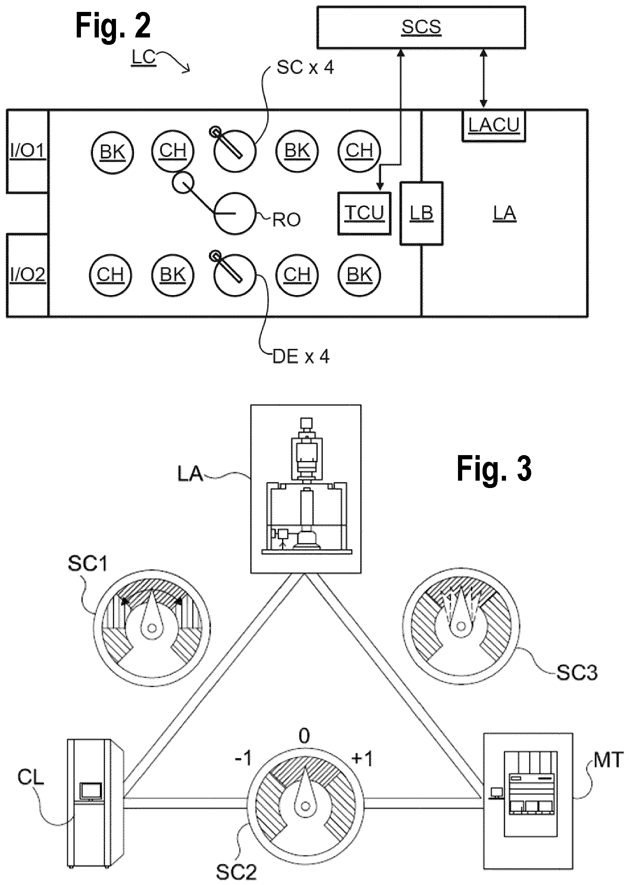

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology tool, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization state. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717Alincorporated herein by reference in its entirety.

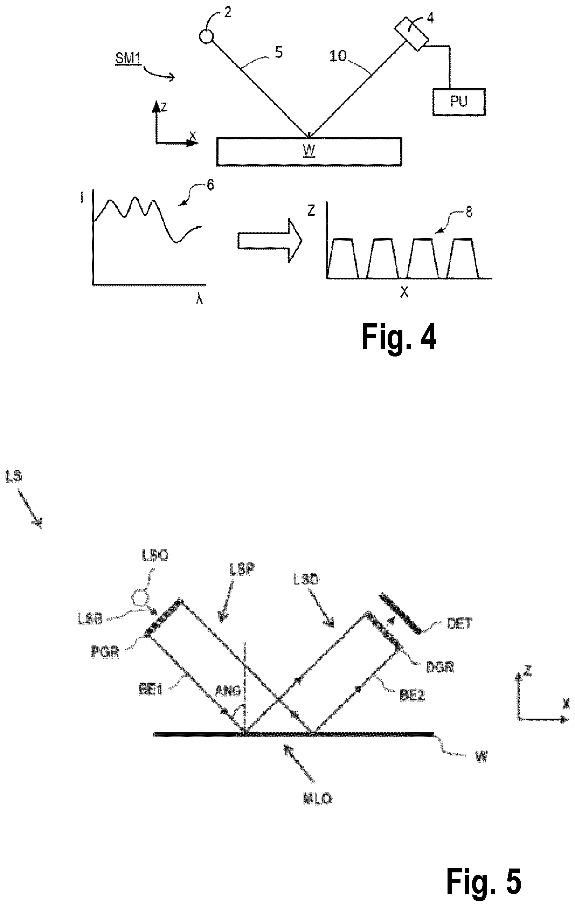

A metrology apparatus, such as a scatterometer SM1, is depicted in figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity In1 as a function of wavelength λ) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometter illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

A topography measurement system, level sensor or height sensor, and which may be integrated in the lithographic apparatus, is arranged to measure a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband radiation source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor. a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, + 1st order, -1st order, +2nd order and -2nd order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads are arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks. Each mark is a structure whose position can be measured at a later time using a position sensor, typically an optical position sensor. The position sensor may be referred to as "alignment sensor" and marks may be referred to as "alignment marks". A mark may also be referred to as a metrology target.

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

A mark, or alignment mark, may comprise a series of bars formed on or in a layer provided on the substrate or formed (directly) in the substrate. The bars may be regularly spaced and act as grating lines so that the mark can be regarded as a diffraction grating with a well-known spatial period (pitch). Depending on the orientation of these grating lines, a mark may be designed to allow measurement of a position along the X axis, or along the Y axis (which is oriented substantially perpendicular to the X axis). A mark comprising bars that are arranged at +45 degrees and/or -45 degrees with respect to both the X- and Y-axes allows for a combined X- and Y- measurement using techniques as described in US2009/195768A, which is incorporated by reference.

The alignment sensor scans each mark optically with a spot of radiation to obtain a periodically varying signal, such as a sine wave. The phase of this signal is analyzed, to determine the position of the mark and, hence, of the substrate relative to the alignment sensor, which, in turn, is fixated relative to a reference frame of a lithographic apparatus. So-called coarse and fine marks may be provided, related to different (coarse and fine) mark dimensions, so that the alignment sensor can distinguish between different cycles of the periodic signal, as well as the exact position (phase) within a cycle. Marks of different pitches may also be used for this purpose.

Measuring the position of the marks may also provide information on a deformation of the substrate on which the marks are provided, for example in the form of a wafer grid. Deformation of the substrate may occur by, for example, electrostatic clamping of the substrate to the substrate table and/or heating of the substrate when the substrate is exposed to radiation.

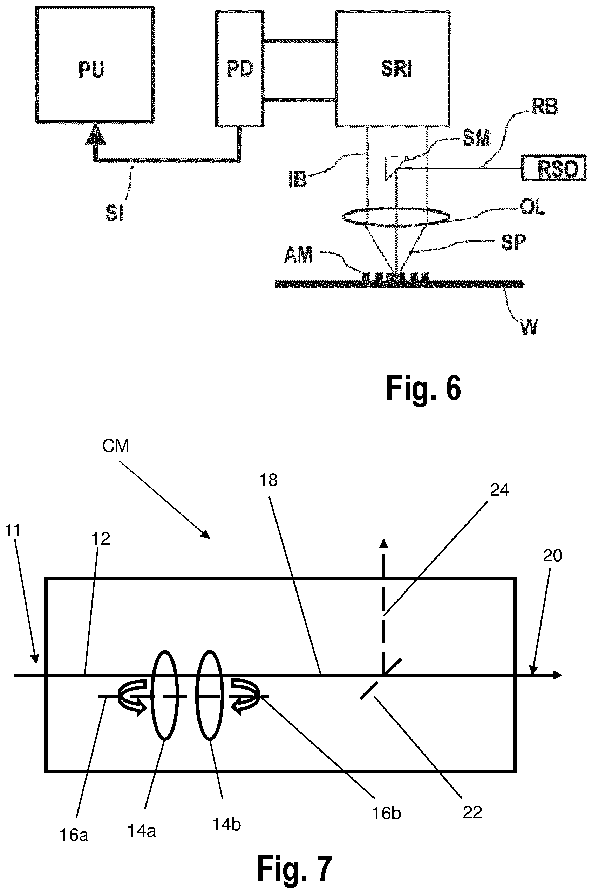

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology and/or inspection tools (also referred to as measurement tools) such as the ones described above often use radiation to obtain measurement data. Depending on the measurement target and the properties to be measured, different types of radiation may be used. One differing property of radiation is the wavelength(s) used to obtain a measurement, as different wavelengths may provide different information about a measurement target. Some measurement tools may use broadband radiation, such as supercontinuum radiation, either to measure using broadband radiation, or to be able to tune and select the measurement wavelength(s) to be used. Depending on the range of output wavelengths and properties of the broadband source, difference methods may be used to obtain the broadband radiation. In some implementations for generating broadband radiation, nonlinear effects may be used to broaden narrow wavelength range input radiation (also referred to as pump radiation). Different known setups and methods exist to achieve nonlinear broadening. Often these methods rely on the confinement of the pump radiation to achieve high intensities needed to experience significant nonlinear effects.

Embodiments of the invention may advantageously provide a radiation source that is able to switch quickly between desired wavelengths - i.e. desired central wavelength and desired spectral bandwidth (e.g. through the use of a colour selection module which includes automated movable dispersive arrangements provided at an output of the radiation source).

In order to provide a radiation source that is able to switch between desired wavelengths, the radiation source may include a colour selection module CM, a known example of which is depicted schematically in Figure 7. The colour selection module CM is provided with an input 11 for a beam of broadband radiation 12. The beam of radiation 12 passes through a pair of rotatable colour wheels 14a, 14b. The colour wheels 14a, 14b may each be considered to be multilayer (spectral) filters. That is to say, each colour wheel has a multilayer structure - each layer being formed from different materials each having a different transmission spectrum. The overall transmission spectrum of a particular portion of each colour wheel depends upon the thickness and material of each layer of the multilayer structure at said portion. One or more properties of the multilayer structure (e.g. thickness of each of the layers of the multilayer structure) is varied as a function of angular location around the wheel. As such, the overall transmission spectrum of each colour wheel varies as a function of angular location around the wheel. Each of the wheels 14a, 14b can be rotated about a respective rotation axis 16a, 16b. It follows that the overall transmission spectrum of each of the colour wheels 14a, 14b varies with angular location about the rotation axis 16a, 16b. By rotating each of the colour wheels 14a, 14b about their respective axis 16a, 16b and controlling the angular position of each of the colour wheels 14a, 14b, this controls the portion of each of the colour wheel through which the broadband radiation beam 12 passes, and hence the overall transmission spectrum of the multilayer structure of said portion of each colour wheel through which the radiation beam 12 passes. This hence controls properties of a narrowband beam of radiation 18 which is output from the colour wheels 14a, 14b. For example, one of the colour wheels 14a may function as a low pass filter and the other of the colour wheels 14b may function as a high pass filter. By controlling the angular position of each of the colour wheels 14a, 14b, about their respective axis 16a, 16b the cut off frequency provided by the low pass filter of one of the colour wheels and the high pass filter of the other of the colour wheels can be varied. In this way, it is possible to control both a central wavelength and a spectral bandwidth of the narrowband radiation 18 which is output from the colour wheels 14a, 14b. The narrowband radiation 18 exits at an output 20 of the colour selection module CM.

The colour selection module CM may also include a reflector 22 which creates a secondary beam path 24 that can be used to calibrate the colour selection module CM (i.e. ensure that when the colour wheels 14a, 14b are in particular positions, the correct central wavelength and spectral bandwidth of narrowband radiation is output by the colour selection module) and measure properties of the narrowband radiation as the colour selection module CM is operating.

The colour wheels 14a, 14b are relatively large (as their size is, in part, dictated by the properties of the multilayer structures which form part of each of the colour wheels and which must necessarily be of particular size to enable a desired degree of spatial resolution depending on the angular position of the colour wheels). It has been found that the mass of the colour wheels, in combination with the momentum of each of the colour wheels when they are moving, together with the distance required to move each of the colour wheels so as to change the central wavelength and spectral bandwidth of the narrowband radiation output by the colour selection module, limits the switching speed of the colour selection module. That is to say, when it is desired to switch between i) a first desired central wavelength and spectral bandwidth of narrowband radiation and ii) a second desired central wavelength and spectral bandwidth of narrowband radiation, the speed in doing so is undesirably slow. This results in the speed/throughput of the metrology tool (and hence a lithographic apparatus of which the metrology tool forms part) being undesirably reduced.

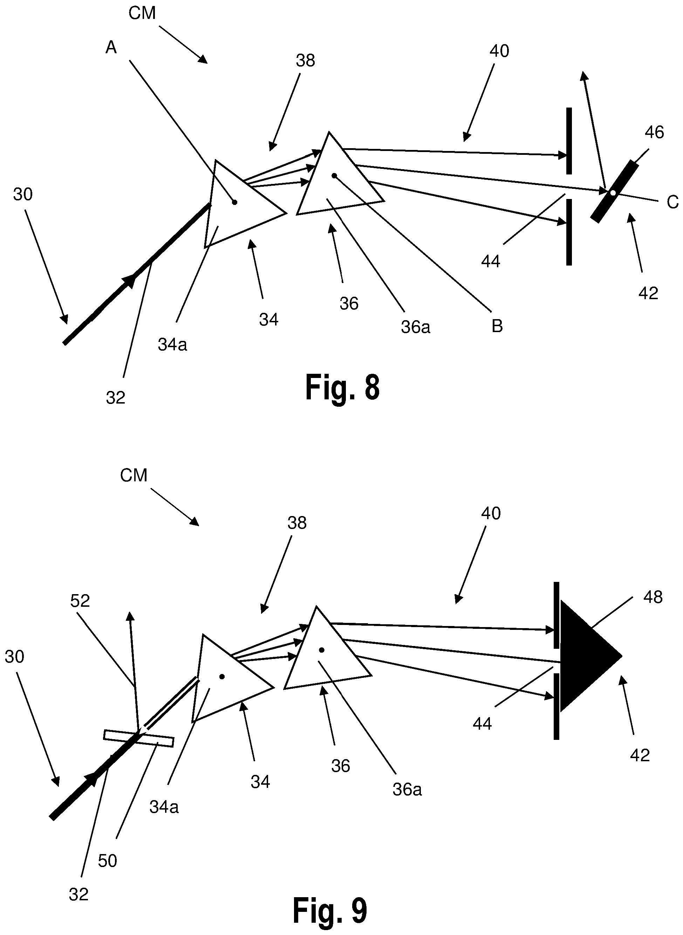

Figure 8 depicts a first embodiment of a colour selection module CM in accordance with the present invention. The colour selection module CM is suitable for outputting narrowband radiation which has both a desired spectral bandwidth and a desired central wavelength. That is to say, the colour selection module CM is capable of controlling the spectral bandwidth and the central wavelength of the output narrowband radiation.

The colour selection module CM includes a radiation input 30 configured to, in use, receive an input beam of radiation 32.

The colour selection module CM further includes a first dispersive arrangement 34 and a second dispersive arrangement 36. The first dispersive arrangement 34 is configured to, in use, receive the input beam of radiation 32 from the radiation input 30 and output a first dispersed beam of radiation 38.

The second dispersive arrangement 36 is configured to, in use, receive at least a portion of the first dispersed beam of radiation 38 and output a second dispersed beam of radiation 40.

The colour selection module CM further includes a radiation output arrangement 42 configured to, in use, to receive at least a portion of the second dispersed beam of radiation 40 and output the second dispersed beam of radiation 40 from the colour selection module CM.

In the present embodiment the first dispersive arrangement 34 takes a form of a prism 34a and the second dispersive arrangement 36 takes the form of a second prism 36a.

A portion of the first dispersive arrangement 34 is mechanically linked to a first actuator (not shown). The first actuator is configured to, in use, rotate said portion of the first dispersive arrangement, whereby a rotation of said portion of the first dispersive arrangement changes a first angle of incidence of the input beam of radiation 32 on said portion of the first dispersive arrangement and hence a first direction of travel and a first spatial distribution of the first dispersed beam of radiation. In the present case, the first prism 34a of the first dispersive arrangement 34 is mechanically linked to the first actuator which rotates the first prism 34a about a first rotation axis A.

A portion of the second dispersive arrangement 36 is mechanically linked to a second actuator (not shown). The second actuator is configured to, in use, rotate said portion of the second dispersive arrangement 36, whereby rotation of said portion of the second dispersive arrangement changes a second angle of incidence of said first dispersed beam of radiation 38 on said portion of the second dispersive arrangement 36 and hence a second direction of travel and a second spatial distribution of the second dispersed beam of radiation 40. In the present case, the second prism 36a of the second dispersive arrangement 36 is mechanically linked to the second actuator so that the second actuator can rotate the second prism 36a about a second rotation axis B.

It should be appreciated that besides being mechanically linked, any of the actuators in this or other embodiments may be coupled through other means like magnets or any other appropriate actuator or coupling means may be used.

By changing the second direction of travel and second spatial distribution of the second dispersed beam of radiation 40, rotating the second prism 36a changes a wavelength band of said at least a portion of said second dispersed beam of radiation which is received and output by the radiation output arrangement 42. In particular, in the present case, the radiation output arrangement 42 comprises an aperture 44 through which said at least portion of said second dispersed beam of radiation 40 passes. The size and location of the aperture 44 acts to spatially filter a portion of the second dispersed beam of radiation 40 and thereby determine the wavelength band of the portion of the second dispersed beam of radiation 40 which is output by the radiation output arrangement 42.

In the present embodiment, given that the aperture 44 of the output arrangement 42 is of a fixed size and location, rotating the prisms 34a, 34b so as to cause a desired wavelength band of radiation to pass through the aperture 44, will result a change in the direction of travel of the portion of the second dispersed beam of radiation 40 passing through the aperture. So as to manage this change in direction of the portion of the second dispersed beam of radiation which passes through the aperture of the output arrangement, an output reflector 46 is configured to receive said at least portion of said second dispersed beam of radiation (which is travelling in a third direction of travel through the aperture), once it has passed through the aperture, and output the received portion of the second dispersed beam of radiation in a fourth direction of travel, different to the third direction of travel. The output reflector is mounted for rotation about an axis C and is driven by a third actuator (not shown). Rotating the output reflector changes a third angle of incidence of said at least a portion of said second disbursed beam of radiation on the output reflector and hence changes the fourth direction of travel of the radiation output from the output reflector.

In this way, the output reflector can be used to ensure that, regardless of the direction of the chosen wavelength band, the second dispersed beam of radiation which passes through the aperture of the output arrangement can be directed so that it exits the colour selection module CM at a correct direction/location so that the radiation output by the colour selection module CM can be utilised by the metrology system and/or lithographic apparatus of which it forms part.

It should be appreciated that where it is mentioned that an embodiment comprises an aperture, this can also be read as comprises a spatial filter. Such a spatial filter can be for example be an aperture, an apodizer or any other appropriate means to spatially filter a portion of a light beam.

By replacing the relatively large and heavy colour wheels of the known types of colour selection module with relatively small (and therefore lighter) rotatable dispersive elements (in the present case prisms, although, as discussed in more detail further below, other dispersive elements are possible) the speed with which the colour selection module can select a desired wavelength band of narrowband radiation output by the colour selection module is increased, thereby increasing the potential throughput of the metrology tool/lithography apparatus of which the colour selection module forms part.

Furthermore, the angular movement required by a prism in order to result in a desired change in spectral properties of the radiation output by the colour selection module may be much smaller than that required of a colour wheel to produce the same change. Again, for this reason, it is possible for an actuator to drive a prism more quickly than a colour wheel so as to effect the desired change in spectral properties of the radiation output by the colour selection module. Therefore, a desired change in spectral properties of the radiation output by the colour selection module can be effected more quickly, thereby reducing the time taken for the relevant metrology tool and/or lithographic apparatus to switch between different wavelengths of radiation, hence increasing throughput.

It will be appreciated that, in accordance with the present invention (whether in relation to the present embodiment or later described embodiments) the axis of rotation of each of the rotatable portions of the first dispersive arrangement and second dispersive arrangement are generally non-parallel to the direction of travel of the beam of radiation which is incident upon them (in the case of the first dispersive arrangement: the input beam of radiation; and in the case of the second dispersive arrangement: said portion of the first dispersed beam of radiation). In this particular example, the axis of rotation of the relevant portions of the first and second dispersive arrangements may be generally perpendicular to the direction of travel of the beam of radiation incident thereon. In other embodiments, the axis of rotation of the relevant portions of the first and second dispersive arrangements need not be generally perpendicular to the direction of travel of the beam of radiation incident thereon.

The portions of the first and second dispersive arrangements which are rotated about an axis on which the centre of mass of the relevant rotatable portion sits. This helps to ensure that the actuators driving the relevant portions for rotation are driving something which is balanced for rotation, thereby minimising the stress on the system. In other embodiments, the portions of the first and second dispersive arrangements which are rotated need not be rotated about an axis on which the centre of mass of the relevant rotatable portion sits.

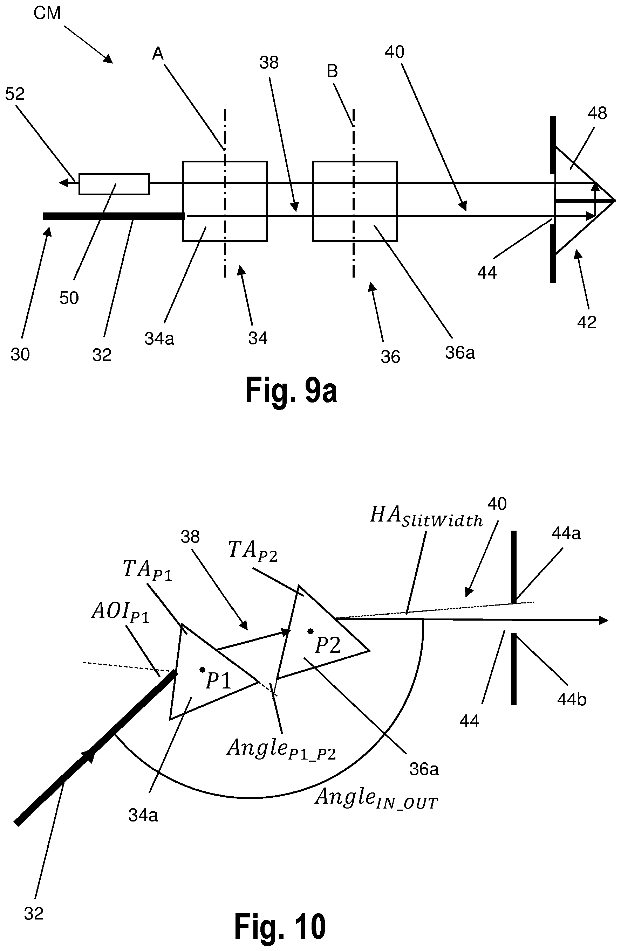

As previously discussed, the wavelength band selected for outputting from the colour selection module will, in the embodiment shown in Figure 8, affect the angle at which the portion of the second dispersed beam of radiation passes through the aperture 44 of the output arrangement 42. As previously discussed, an output reflector 46 can be used to correct for such changes in the direction of travel of the selected portion of said second dispersed beam of radiation. Figure 9 depicts a second embodiment to the present invention in which the need for a moveable output reflector is avoided.

Within the embodiment shown in Figure 9, equivalent features to those shown in the embodiment of Figure 8 have been given the same reference numerals. For the sake of brevity, only the differences between the embodiments shown in Figures 8 and 9 are discussed.

The output reflector of the embodiment in Figure 8 has been replaced by a retroreflector 48, such that the aperture 44 of the output arrangement 42 is located, with respect to the path of radiation through the system, between the first and second dispersive arrangements 34, 36 and the retroreflector 48. The retroreflector 48 is configured to receive said at least a portion of said second dispersed beam of radiation 40, travelling in a third direction of travel, once it has passed through the aperture 44. The retroreflector 48 is further configured to output the received said at least a portion of said second dispersed beam of radiation in a fourth direction of travel which is opposite to the third direction of travel. As can be best seen from the side view shown in Figure 9a, the retroreflector 48 outputs the received said at least a portion of said second dispersed beam of radiation in said fourth direction of travel, which is not only opposite to the third direction of travel, but is also spaced from it (in the present case, in a direction which is parallel to the axes A and B - i.e. the vertical direction in Figure 9a). As previously discussed, in the present case, the third direction of travel and fourth direction of travel are anti-parallel (i.e. parallel but in opposite directions). In this way, the retroreflector 48 causes the portion of the second dispersed beam of radiation which is incident on the retroreflector 48 to be reflected such that it travels along substantially the same path of the second dispersed beam of radiation before it was incident on the retroreflector, albeit with the beam of radiation reflected by the retroreflector 48 being spaced in a direction parallel to the axes A, B from the beam of radiation incident on the retroreflector 48. That is to say, the radiation which is incident on the retroreflector substantially retraces its path through the system before it was incident on the retroreflector - i.e. such that it passes back through the second prism 36a of the second dispersive arrangement 36 and then back through the first prism 34a of the first dispersive arrangement 34.

The output arrangement 42 further comprises a second reflector 50. The second reflector 50 may be spaced from the beam path of the input beam of radiation 32 in the same direction and with the same distance as the spacing of the beam of radiation reflected by the retroreflector 48 from the beam of radiation incident on the retroreflector 48. Given that, as previously discussed, the retroreflector 48 causes the portion of the second dispersed beam of radiation which passes through the aperture 44 to be reflected back substantially along the beam path of the radiation through the system before it was incident on the retroreflector 48 (i.e. such that the beam of radiation reflected by the retroreflector 48 is anti-parallel to, but spaced from the beam of radiation incident on the retroreflector 48), and given that the second reflector is located such that it is spaced from the beam path of the input beam of radiation 32 in the same direction and with the same distance as the spacing of the beam of radiation reflected by the retroreflector 48 from the beam of radiation incident on the retroreflector 48, the second reflector is configured to receive the portion of said dispersed beam of radiation output by the retroreflector, after said second dispersed beam of radiation output by the retroreflector has interacted with the second dispersive arrangement 36 and first dispersive arrangement 34 (i.e. in the present case, after the relevant radiation has passed through the prisms 34a and 34b for a second time). The second reflector 50 then outputs a recombined beam 52 having a beam path which is different to that of the beam path of the input beam of radiation 32. The recombined beam 52 can then be output from the colour selection module CM and subsequently utilised by the metrology tool and/or lithographic apparatus.

It should be noted that when it is said that the recombined beam 52 has a beam path which is different to that of the beam path of the input beam of radiation 32, different does not mean opposite or anti-parallel. The recombined beam 52 has a beam path which is non-parallel to that of the beam path of the input beam of radiation 32.

As previously discussed, a portion of the first dispersive arrangement 34 is mechanically linked to a first actuator, a portion of the second dispersive arrangement is mechanically linked to a second actuator and the output reflector 46 is mechanically linked to a third actuator. In each case besides being mechanically linked, the actuators may be coupled through other means like magnets or any other appropriate actuator or coupling means may be used. One suitable actuator is one that comprises a galvanometer mechanism. A galvanometer mechanism is one in which an electric current is passed through a coil which is located in a constant magnetic field in order to cause deflection of the coil and whatever the coil is mounted to. The coil may be biased to a rest position by a resilient biasing member, such as a spring. Increased current within the coil will cause an increased deflection of the coil under the action of the permanent magnetic field. Consequently, by varying the current provided to the coil, it is possible to vary the amount of deflection of the coil, and hence the amount of deflection (and hence angular position of) whatever the coil is mechanically linked to.

In one example, each prism of the first and second dispersive arrangement may have three sides which are 10mm in length and a height of 10mm and be made out of F2 glass. Such prisms would have a mass of about 1.8 grams. This is a sufficiently small mass to be compatible with an actuator comprising a galvanometer. Such actuators have been found to have a response time which is less than 1 millisecond.

It will be appreciated that, although the use of a galvanometer mechanism as part of at least one of the first, second or third actuators has been discussed in relation to the previously discussed embodiments of the invention, a galvanometer mechanism can equally form part of one of the actuators which forms part of one of the other embodiments of colour selection module according to the present invention discussed in more detail further below.

In order to model the performance of a colour selection module such as that shown in Figures 8 or 9, a model, as shown in Figure 10, was created and evaluated. Equivalent features within the model shown in Figure 10 and the embodiments shown in Figures 8 and 9 have been given the same reference numerals. The prism 34a of the first dispersive arrangement is also indicated as P1, and the prism 36a of the second dispersive arrangement is also indicated as P2.

In addition to the features indicated in Figures 8 and 9, Figure 10 also shows the following. AOI_{P1} is the angle of incidence that the input beam of radiation 32 makes with the prism 34a of the first dispersive arrangement. TA_{P1} is the prism apex angle of prism 34a and TA_{P2} is the prism apex angle of prism 36a. Angle_{P1_P2} is the angle between a rear face of prism 34a and a front face of prism 36a. The rear face of the first prism may also be referred to as the exit face of the first prism and the front face of the second prism may also be referred to as the incident or entry face of the prism 36a. Angle_{IN_OUT} is the angle subtended between the beam path of the input radiation 32 and the beam path of the second dispersed beam of radiation 40. HA_{SlitWidth} is the half angle defined by the width of the slit 44. The half angle defined by the width of the slit 44 (HA_{SlitWidth}) is defined as half of the angle subtended between i) a first ray which extends between the point on the prism 36a at which the second dispersed beam of radiation exits the prism 36a and a first edge 44a of the slit 44, and ii) a second ray which extends between said point on the prism 36a from which the second dispersed beam of radiation exits the prism 36a and a second edge 44b of the aperture 44.

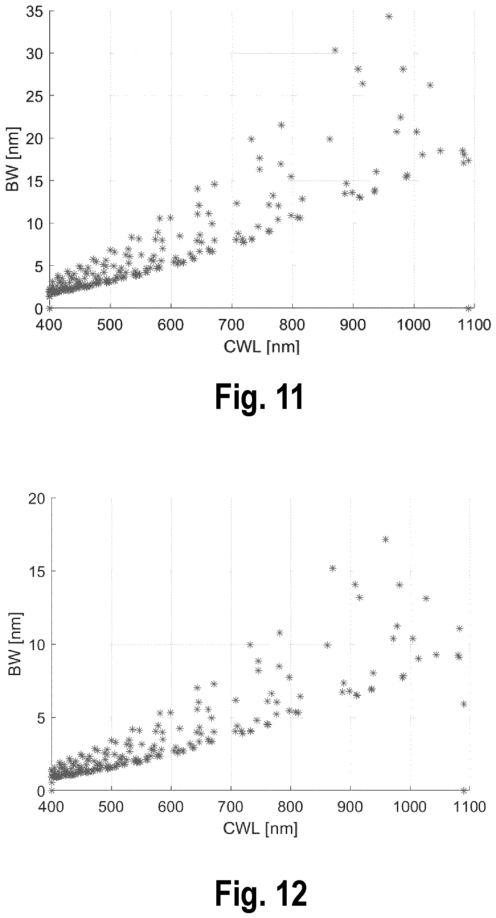

Figures 11, 12, 13, 14, 15 and 16 each show plots of bandwidth of a portion of the second dispersed beam of radiation which passes through the aperture 44 against the central wavelength of said portion of said second dispersed beam of radiation which passes through the aperture 44.

In Figure 11 the apex angle TA_{P1} of prism 34a is 20° and the apex angle TAra of the prism 36a 40°. Angle_{IN_OUT} is -120° and the half angle of the aperture width HA_{SlitWidth} is 0.1°. In order to attain the plot, the angle of incidence on prism 34a AOI_{P1} was varied in 1° steps from 60° to 0°. For each of the different angles of incidence of the input beam of radiation on the prism 34a the angle Angle_{P1_P2} subtended between the prism 34a and prism 36a was varied in 1° increments from -40° to 40°. Varying the variables as discussed, all of the results for which there was a solution were plotted.

The same process and variables were used to create the plot in Figure 12, except that the half angle of the aperture width HA_{SlitWidth} in Figure 12 is 0.05° - half of that used in Figure 11.

By comparing the plots in Figure 11 and Figure 12, it can be seen that by reducing the width of the aperture 44, whilst similar central wavelengths of the portion of the second dispersed beam of radiation which pass through the aperture are possible, in general, the achievable bandwidths the portion of the second dispersed beam of radiation are reduced.

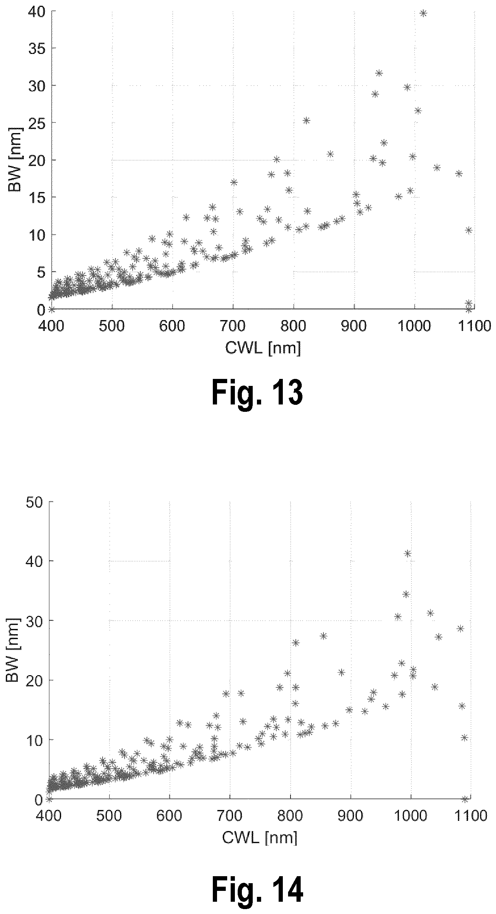

Figures 13 and 14 show plots which use the same methodology and variables as those in Figure 11, except that, in Figure 13 the apex angle TA_{P1} of the prism 34a is 15° and the apex angle TA_{P2} of the prism 36a is 45°; and in Figure 14, the apex angle TA_{P1} of the prism 34a is 25° and the apex angle TA_{P2} of the prism 36a is 35°. It can be seen from Figures 11, 13 and 1 that varying the apex angles of the prisms slightly does not have a significant effect on the achievable central wavelengths of the portion of the second dispersed beam of radiation which passes through the aperture 44, and has a minor effect on the bandwidth of said portion of the second dispersed beam of radiation - the maximum achievable bandwidth in Figure 14 is slightly higher than that in Figure 13, which is slightly higher than that in Figure 11.

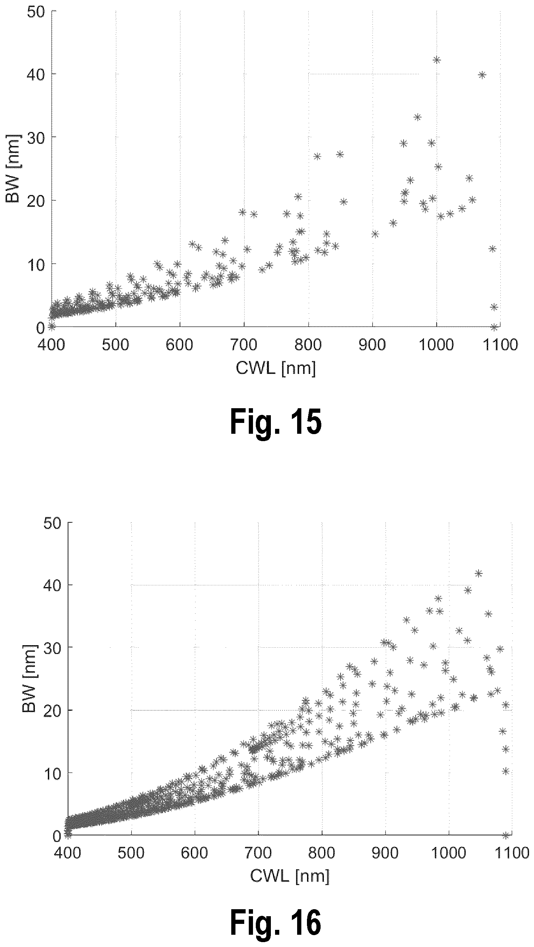

Figure 15 shows a similar scenario to that shown in Figures 11, 13 and 14 except that the apex angles TA_{P1} and TA_{P2} of the prisms 34a and 36a are the same - both being 30°. Again, it can be seen that, whilst this set up results in similar achievable central wavelengths of the portion of the second dispersed beam of radiation, the achievable bandwidth of the produced radiation is slightly different.

Finally, Figure 16 shows the results for the model when the apex angle of each of prisms 34a and 36a is 25°, the angle Angle_{IN_OUT} subtended between the input beam of radiation and second dispersed beam of radiation is approximately -141° and the half angle HA_{SlitWidth} of the aperture width is 0.02°. It can be seen that the results for the model using the variables in Figure 16 shows similar achievable central wavelengths and bandwidths. However, there appears to be a greater density of achievable results which are more uniformly spread in the central wavelength verses bandwidth domain. This may be beneficial as it may mean that the resolution of achievable central wavelengths and bandwidths of the produced radiation is greater for a particular achievable resolution of angular positioning of the first and second prisms 34a and 36a.

It should be noted that, as a result of the non-linear dispersion properties of any prism material, as shown in the previously discussed Figures, the scan range (i.e. how the central wavelength and bandwidth of the second dispersed radiation beam as a function of the angular position of the prisms) is not linear. In practice, smaller bandwidths will be easier to achieve for a relatively short central wavelength of the second dispersed radiation beam, whereas larger bandwidths will be easier to achieve for relatively long central wavelengths of the second dispersed radiation beam.

In the previously described embodiments, as shown in Figures 8 and 9, the first and second dispersive arrangement each utilise a prism as the relevant dispersive element within the dispersive arrangement. In other embodiments the dispersive arrangements may utilise different dispersive elements.

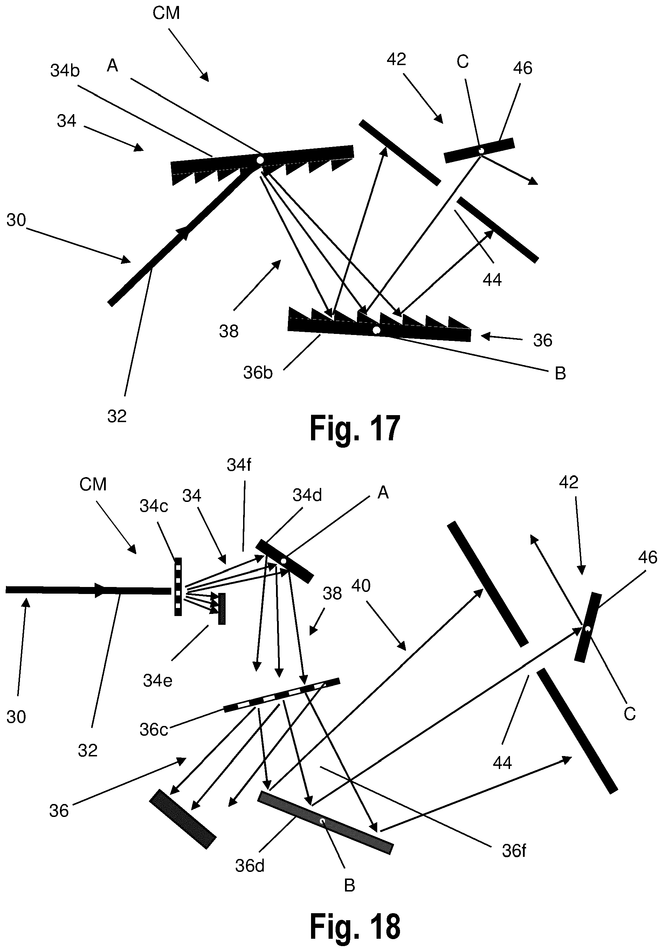

For example, as shown in Figure 17 (in which equivalent features to those in the embodiments shown in Figures 8 and 9 have been given the same reference numerals). The first dispersive arrangement 34 of the colour selection module CM comprises a reflection grating 34b and the portion of the first dispersive arrangement which is mechanically linked to the first actuator is said reflection grating 34b. Likewise, the second dispersive arrangement 36 of the colour selection module CM comprises a second reflection grating 36b and said portion of the second dispersive arrangement 36 which is mechanically linked to the second actuator for rotation is said second reflection grating 36b.

In the alternative embodiment shown in Figure 18, the first dispersive arrangement 34 of the colour selection module CM comprises a transmission grating 34c which receives the input beam of radiation 32 and outputs a first intermediate dispersion beam 34f which is incident on a first dispersion reflector 34d. First dispersion reflector 34d outputs the first dispersed beam of radiation 38. The portion of the first dispersive arrangement 34 which is mechanically linked to an actuator for rotation about axis A is the first dispersion reflector 34d.

As an optional feature, the embodiment shown in Figure 18 also includes a first beam block 34e which forms part of the first dispersive arrangement 34. The beam block 34e is positioned so as to absorb the portion of the radiation output by the first transmission grating 34c which is not directed so as to be incident on the first dispersion reflector 34d.

The second dispersive arrangement 36 comprises a second transmission grating 36c which receives said at least a portion of the first dispersed beam of radiation 38 and outputs a second intermediate dispersion beam 36f which is incident on a second dispersion reflector 36d. The second dispersion reflector 36d outputs said second dispersed beam of radiation 40. The portion of the second dispersive arrangement 36 which is mechanically linked to the second actuator for rotation about axis B is the second dispersion reflector 36d.

Again, as an optional feature, the second dispersive arrangement 36 includes a second beam block 36e which is utilised to absorb the portion of the radiation output by the second transmission grating 36c which is not directed towards the second dispersion reflector 36d.

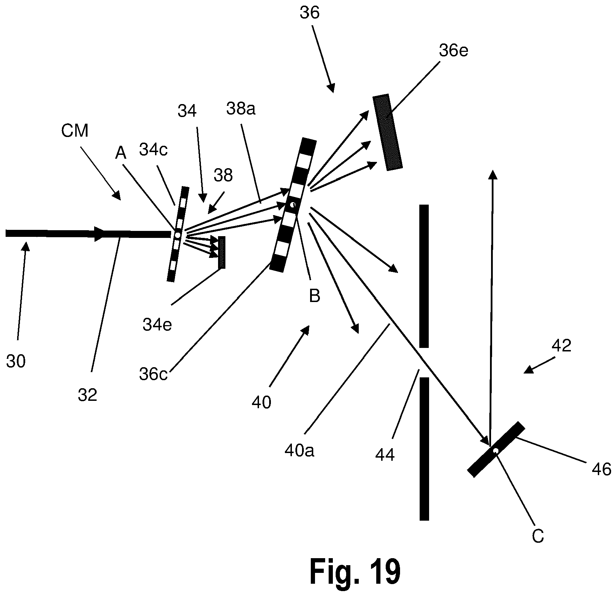

In the alternative embodiment shown in Figure 19, as with the embodiment shown in Figure 18, the first dispersive arrangement 34 of the colour selection module CM comprises a transmission grating 34c which receives the input beam of radiation 32. The transmission grating 34c outputs the first dispersed beam of radiation 38. The portion of the first dispersive arrangement 34 which is mechanically linked to an actuator for rotation about axis A is the transmission grating 34c.

The second dispersive arrangement 36 comprises a second transmission grating 36c which receives said at least a portion 38a of the first dispersed beam of radiation 38 and outputs the second dispersed beam of radiation 40. The portion of the second dispersive arrangement 36 which is mechanically linked to the second actuator for rotation about axis B is the second transmission grating 36c.

A portion 40a of the second dispersed beam of radiation 40 is received and output by the radiation output arrangement 42. In particular, the apportion 40a is received by the aperture 44 of the output arrangement 42 and is re-directed by an output reflector 46, in a similar manner to that as discussed in relation to the embodiment shown in Figure 8.

As an optional feature, the embodiment shown in Figure 19 also includes a first beam block 34e which forms part of the first dispersive arrangement 34. The beam block 34e is positioned so as to absorb the portion of the radiation output by the first transmission grating 34c which is not directed so as to be incident on second transmission grating 36c.

Again, as an optional feature, the second dispersive arrangement 36 includes a second beam block 36e which is utilised to absorb the portion of the radiation output by the second transmission grating 36c which is not directed towards the aperture 44 of the output arrangement 44.

As with the embodiments of the invention shown in Figures 8 and 9, the embodiments shown in Figures 17, 18 and 19 operate in a similar manner in which rotating the relevant portions of the first and second dispersive arrangements changes the direction of travel and spatial distribution of the first dispersed beam of radiation and second dispersed beam of radiation and hence the wavelength band of at least a portion of the second dispersed beam of radiation which is received and output by the radiation output arrangement 44.

Furthermore, each of the embodiments shown in Figures 17, 18 and 19 include a radiation output arrangement 42 which includes an output reflector 46 which operates in the same manner as that described with reference to the embodiment in Figure 8. Of course, the output arrangements of the embodiments shown in 17, 18 and 19 could, instead, include a retroreflector and second reflector which operate in the same manner as those discussed in relation to the embodiment shown in Figure 9.

In some embodiments, the use of gratings (either transmission or reflection) as dispersion elements, as compared to prisms, may be undesirable. This is particularly the case in which the full spectrum of radiation that it is desired for the colour selection module to be able to emit spans more than one octave (i.e. the lowest desired central wavelength to be emitted by the colour selection module is less than half of the highest desired central wavelength to be emitted by the colour selection module). Furthermore, prisms may be a more desirable choice than gratings when selecting a suitable dispersive element, as when dispersive elements are used to control the spectral bandwidth of the radiation output by a colour selection module, prisms have a much lower spectral resolution than gratings. That is to say, a relatively small annular adjustment to the angular position of the prism can result in a relatively large change in the spatial distribution of the wavelengths of radiation output by the prism. This means that using the angular position of prisms as dispersive elements to control the spectral properties of the radiation output by the colour selection module may be easier than for other types of dispersive element.

It may be possible to alter variables within the embodiments of the colour selection modules discussed herein so as to further maximise the ability of the colour selection module to choose an output radiation having the desired spectral properties. For example, the colour selection module could use further dispersive arrangements between the input to the colour selection module and the output thereof. In addition, or alternatively, it may be possible to use an output arrangement which includes an aperture which has a diameter which can be varied, or the aperture can be movable such that the location can be varied by for example a movement in or out of the plane of the aperture.

In the previously discussed embodiments, in each respective embodiment, the dispersive elements of each of the first and second dispersive arrangements are of the same type. This need not be the case. For example, in some embodiments the dispersive element of one of the dispersive arrangements may be a prism and the dispersive element of the other dispersive arrangement may be a grating.

Further embodiments are disclosed in the subsequent list of numbered clauses:
1. A colour selection module, for outputting radiation having a desired spectral bandwidth and central wavelength, comprising:
   a radiation input for receiving an input beam of radiation;
   a first dispersive arrangement for receiving the input beam of radiation from the radiation input and outputting a first dispersed beam of radiation;
   a second dispersive arrangement for receiving at least a portion of the first dispersed beam of radiation and outputting a second dispersed beam of radiation;
   a radiation output arrangement for receiving at least a portion of said second dispersed beam of radiation and outputting said at least a portion of said second dispersed beam of radiation from the colour selection module; wherein
   a portion of the first dispersive arrangement is coupled to a first actuator for rotating said portion of the first dispersive arrangement; and
   a portion of the second dispersive arrangement is coupled to a second actuator for rotating said portion of the second dispersive arrangement, whereby rotation of said portion of the second dispersive arrangement changes a second direction of travel and a second spatial distribution of the second dispersed beam of radiation, and hence spectral bandwidth and central wavelength of said at least a portion of said second dispersed beam of radiation received and output by the radiation output arrangement.
2. A colour selection module according to clause 1, wherein the first dispersive arrangement comprises a prism and said portion of the first dispersive arrangement is said prism.
3. A colour selection module according to clause 1, wherein a) the first dispersive arrangement comprises a reflection grating and said portion of the first dispersive arrangement is said reflection grating; or b) the first dispersive arrangement comprises a transmission grating and said portion of the first dispersive arrangement is said transmission grating.
4. A colour selection module according to clause 1, wherein the first dispersive arrangement comprises a transmission grating, which receives the input beam of radiation and outputs a first intermediate dispersion beam which is incident on a first dispersion reflector, the first dispersion reflector outputting said first dispersed beam of radiation; and wherein said portion of the first dispersive arrangement is said first dispersion reflector.
5. A colour selection module according to clause 1, 2, 3 or 4 wherein the second dispersive arrangement comprises a second prism and said portion of the second dispersive arrangement is said second prism.
6. A colour selection module according to clause 1, 2, 3 or 4 wherein a) the second dispersive arrangement comprises a second reflection grating and said portion of the second dispersive arrangement is said second reflection grating; or b) the second dispersive arrangement comprises a second transmission grating and said portion of the second dispersive arrangement is said second transmission grating.
7. A colour selection module according to clause 1, 2, 3 or 4 wherein the second dispersive arrangement comprises a second transmission grating, which receives said at least a portion of the first dispersed beam of radiation and outputs a second intermediate dispersion beam which is incident on a second dispersion reflector, the second dispersion reflector outputting said second dispersed beam of radiation; and wherein said portion of the second dispersive arrangement is said second dispersion reflector.
8. A colour selection module according to any preceding clause, wherein the radiation output arrangement comprises a spatial filter through which said at least a portion of said second dispersed beam of radiation passes.
9. A colour selection module according to clause 8, wherein the radiation output arrangement further comprises an output reflector for receiving said at least a portion of said second dispersed beam of radiation, travelling in a third direction of travel, once it has passed through the spatial filter and output the received said at least a portion of said second dispersed beam of radiation in a fourth direction of travel, different to the third direction of travel.
10. A colour selection module according to clause 9, wherein the output reflector is coupled to a third actuator, for rotating the output reflector, whereby rotation of the output reflector changes a third angle of incidence of said at least a portion of said second dispersed beam of radiation on the output reflector and hence the fourth direction of travel of the radiation output from the output reflector.
11. A colour selection module according to clause 8, wherein the radiation output arrangement further comprises a retroreflector for receiving said at least a portion of said second dispersed beam of radiation, travelling in a third direction of travel, once it has passed through the spatial filter and output the received said at least a portion of said second dispersed beam of radiation in a fourth direction of travel, opposite to the third direction of travel.
12. A colour selection module according to clause 11, wherein the radiation output arrangement further comprises a second reflector, for receiving said at least a portion of said second dispersed beam of radiation output by the retroreflector, after said at least a portion of said second dispersed beam of radiation output by the retroreflector has interacted with the second dispersive arrangement and first dispersive arrangement, and consequently outputting a recombined beam having a beam path which is different to that of said beam path of the input beam of radiation.
13. A colour selection module according to any preceding clause wherein at least one of the first and second actuators, or both of the first and second actuators, comprise a galvanometer mechanism.
14. A metrology tool comprising the colour selection module of any preceding clause.
15. A lithographic apparatus comprising the colour selection module of any of clauses 1 to 13 or the metrology tool of clause 14.
16. A method of operating a colour selection module to output radiation having a desired spectral bandwidth and central wavelength, the method comprising:
   receiving an input beam of radiation;
   a first dispersive arrangement receiving the input beam of radiation from the radiation input and outputting a first dispersed beam of radiation;
   a second dispersive arrangement receiving at least a portion of the first dispersed beam of radiation and outputting a second dispersed beam of radiation;
   a radiation output arrangement receiving at least a portion of said second dispersed beam of radiation and outputting said at least a portion of said second dispersed beam of radiation from the colour selection module;
   rotating to a first angular position a portion of the first dispersive arrangement;
   rotating to a second angular position a portion of the second dispersive arrangement; and setting the first angular position of said portion of the first dispersive arrangement and the second angular position of said portion of the second dispersive arrangement based on said desired spectral bandwidth and central wavelength.
17. A method according to clause 16, wherein
   the colour selection module comprises a radiation input, said radiation input receiving said input beam of radiation;
   said portion of the first dispersive arrangement is coupled to a first actuator, said first actuator rotating the portion of the first dispersive arrangement to the first angular position;
   said portion of the second dispersive arrangement being coupled to a second actuator, said second actuator rotating the portion of the second dispersive arrangement to the second angular position; rotation of said portion of the first dispersive arrangement changes a first direction of travel and a first spatial distribution of the first dispersed beam of radiation; and
   rotation of said portion of the second dispersive arrangement changes a second direction of travel and a second spatial distribution of the second dispersed beam of radiation, and hence spectral bandwidth and central wavelength of said at least a portion of said second dispersed beam of radiation received and output by the radiation output arrangement.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology tool, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

## Claims

1. A colour selection module, for outputting radiation having a desired spectral bandwidth and central wavelength, comprising:
a radiation input for receiving an input beam of radiation;
a first dispersive arrangement for receiving the input beam of radiation from the radiation input and outputting a first dispersed beam of radiation;
a second dispersive arrangement for receiving at least a portion of the first dispersed beam of radiation and outputting a second dispersed beam of radiation;
a radiation output arrangement for receiving at least a portion of said second dispersed beam of radiation and outputting said at least a portion of said second dispersed beam of radiation from the colour selection module; wherein
a portion of the first dispersive arrangement is coupled to a first actuator for rotating said portion of the first dispersive arrangement; and
a portion of the second dispersive arrangement is coupled to a second actuator for rotating said portion of the second dispersive arrangement, whereby rotation of said portion of the second dispersive arrangement changes a second direction of travel and a second spatial distribution of the second dispersed beam of radiation, and hence spectral bandwidth and central wavelength of said at least a portion of said second dispersed beam of radiation received and output by the radiation output arrangement.

2. A colour selection module according to claim 1, wherein the first dispersive arrangement comprises a prism and said portion of the first dispersive arrangement is said prism.

3. A colour selection module according to claim 1, wherein a) the first dispersive arrangement comprises a reflection grating and said portion of the first dispersive arrangement is said reflection grating; or b) the first dispersive arrangement comprises a transmission grating and said portion of the first dispersive arrangement is said transmission grating.

4. A colour selection module according to claim 1, wherein the first dispersive arrangement comprises a transmission grating, which receives the input beam of radiation and outputs a first intermediate dispersion beam which is incident on a first dispersion reflector, the first dispersion reflector outputting said first dispersed beam of radiation; and wherein said portion of the first dispersive arrangement is said first dispersion reflector.

5. A colour selection module according to claim 1, 2, 3 or 4 wherein the second dispersive arrangement comprises a second prism and said portion of the second dispersive arrangement is said second prism.

6. A colour selection module according to claim 1, 2, 3 or 4 wherein a) the second dispersive arrangement comprises a second reflection grating and said portion of the second dispersive arrangement is said second reflection grating; or b) the second dispersive arrangement comprises a second transmission grating and said portion of the second dispersive arrangement is said second transmission grating.

7. A colour selection module according to claim 1, 2, 3 or 4 wherein the second dispersive arrangement comprises a second transmission grating, which receives said at least a portion of the first dispersed beam of radiation and outputs a second intermediate dispersion beam which is incident on a second dispersion reflector, the second dispersion reflector outputting said second dispersed beam of radiation; and wherein said portion of the second dispersive arrangement is said second dispersion reflector.

8. A colour selection module according to any preceding claim, wherein the radiation output arrangement comprises a spatial filter through which said at least a portion of said second dispersed beam of radiation passes.

9. A colour selection module according to claim 8, wherein the radiation output arrangement further comprises an output reflector for receiving said at least a portion of said second dispersed beam of radiation, travelling in a third direction of travel, once it has passed through the spatial filter and output the received said at least a portion of said second dispersed beam of radiation in a fourth direction of travel, different to the third direction of travel.

10. A colour selection module according to claim 9, wherein the output reflector is coupled to a third actuator, for rotating the output reflector, whereby rotation of the output reflector changes a third angle of incidence of said at least a portion of said second dispersed beam of radiation on the output reflector and hence the fourth direction of travel of the radiation output from the output reflector.

11. A colour selection module according to claim 8, wherein the radiation output arrangement further comprises a retroreflector for receiving said at least a portion of said second dispersed beam of radiation, travelling in a third direction of travel, once it has passed through the spatial filter and output the received said at least a portion of said second dispersed beam of radiation in a fourth direction of travel, opposite to the third direction of travel.

12. A colour selection module according to claim 11, wherein the radiation output arrangement further comprises a second reflector, for receiving said at least a portion of said second dispersed beam of radiation output by the retroreflector, after said at least a portion of said second dispersed beam of radiation output by the retroreflector has interacted with the second dispersive arrangement and first dispersive arrangement, and consequently outputting a recombined beam having a beam path which is different to that of said beam path of the input beam of radiation.

13. A colour selection module according to any preceding claim wherein at least one of the first and second actuators, or both of the first and second actuators, comprise a galvanometer mechanism.

14. A metrology tool comprising the colour selection module of any preceding claim.

15. A method of operating a colour selection module to output radiation having a desired spectral bandwidth and central wavelength, the method comprising:
receiving an input beam of radiation;
a first dispersive arrangement receiving the input beam of radiation from the radiation input and outputting a first dispersed beam of radiation;
a second dispersive arrangement receiving at least a portion of the first dispersed beam of radiation and outputting a second dispersed beam of radiation;
a radiation output arrangement receiving at least a portion of said second dispersed beam of radiation and outputting said at least a portion of said second dispersed beam of radiation from the colour selection module;
rotating to a first angular position a portion of the first dispersive arrangement;
rotating to a second angular position a portion of the second dispersive arrangement; and
setting the first angular position of said portion of the first dispersive arrangement and the second angular position of said portion of the second dispersive arrangement based on said desired spectral bandwidth and central wavelength.
